# EUROPÄISCHE PATENTSCHRIFT

(11) **EP 0 833 245 B1**
(45) Veröffentlichungstag und Bekanntmachung des Hinweises auf die Patenterteilung: **26.02.2003**
(21) Anmeldenummer: 97116648.3
(22) Anmeldetag: 24.09.1997
(51) Int. Cl.: G06F 9/38, G06F 7/52

(54) **Schaltungsanordnung mit zwischen Registern angeordneten kombinatorischen Blöcken**
Circuit with combinatorial logic blocks located between registers
Circuit de blocs de logique combinatoire disposés entre registres

(30) Priorität: 27.09.1996 DE 19639935
(43) Veröffentlichungstag der Anmeldung: 01.04.1998
(73) Patentinhaber: Infineon Technologies AG, 81669 München (DE)
(72) Erfinder: Ecker, Wolfgang, Dr., 81377 München (DE)
(74) Vertreter: Graf Lambsdorff, Matthias, Dr.

(56) Entgegenhaltungen:
- US-A- 3 947 671
- US-A- 4 276 607
- PATENT ABSTRACTS OF JAPAN vol. 009, no. 129 (P-361), 5.Juni 1985 & JP 60 014325 A (FUJI XEROX KK), 24.Januar 1985,

## Beschreibung

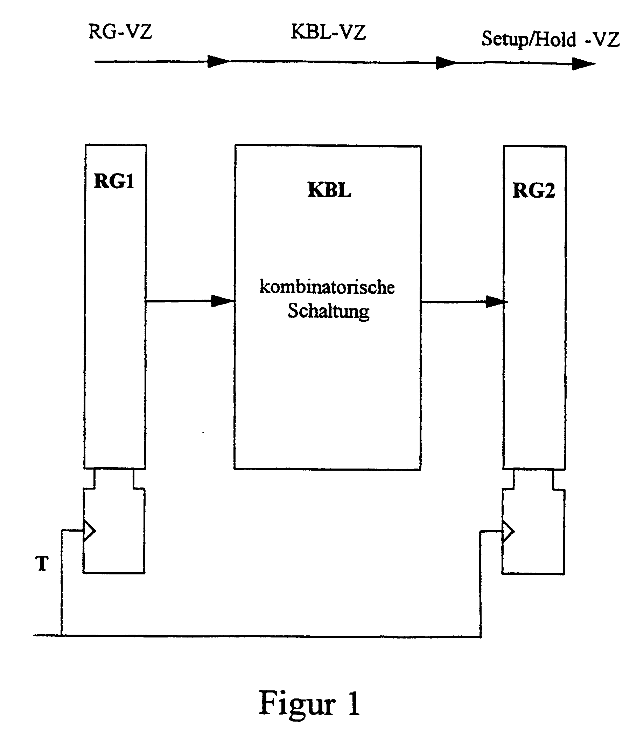

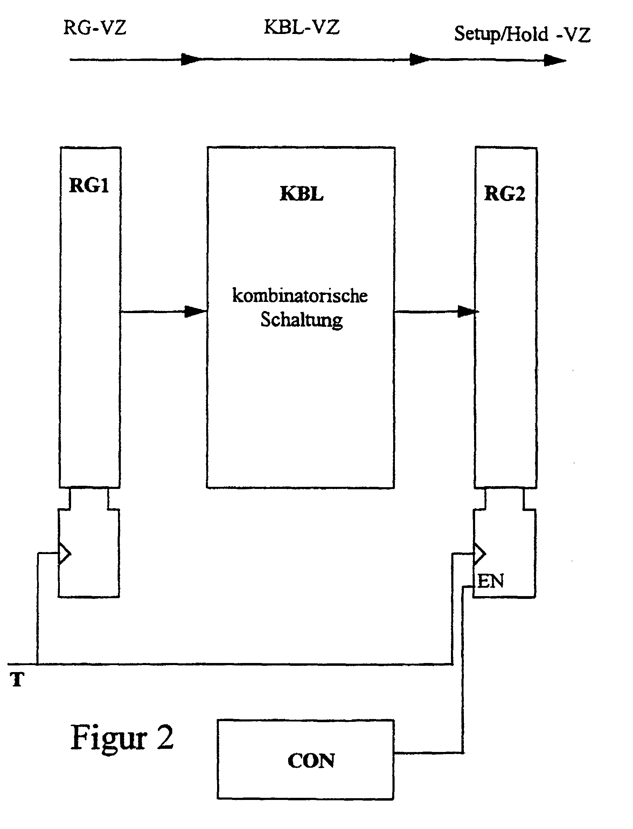

Bei der Entwicklung von synchronen Schaltungen liegen zwischen Registern (im folgenden Eingangsregister RG1 und Ausgangsregister RG2 genannt) immer sogenannte kombinatorische Blöcke KBL (siehe Figur 1, 2). Um die physikalisch bedingten Setup- und Hold-Zeiten einzuhalten, gibt es heutzutage drei Prinzipien kombinatorische Blöcke und Register anzuordnen:
- Die Laufzeit/Verzögerungszeit KBL-VZ von Wertänderungen durch die kombinatorischen Blöcke KBL ist kleiner als die Taktperiode minus der Setup-Zeit Setup/Hold-VZ und minus der Signallaufzeit RG-VZ durch ein Register RG. Dies ist in Figur 1 dargestellt. Zwischen ein Eingangsregister RG1 und Ausgangsregister RG2 ist ein kombinatorischer Block KBL geschaltet. Die Register RG1 und RG2 werden mit einem Taktsignal T angesteuert.
- Die Laufzeit von Wertänderungen durch die kombinatorischen Blöcke KBL ist um einen Faktor N größer als eine Taktperiode des Taktsignales T. Das Ergebnis wird aber erst N Taktsignale später am Ausgang des Ausgangsregisters RG2 nach den kombinatorischen Blöcken KBL abgegriffen.
- Die Laufzeit von Wertänderungen durch die kombinatorischen Blöcke KBL ist um einen Faktor N größer als eine Taktperiode des Taktsignales T. Das Ergebnis wird aber erst N Taktsignale später in das Ausgangsregister RG2 nach den kombinatorischen Blöcken KBL eingespeichert. Dazu wird eine Enable-Anschluß EN an dem Ausgangsregister RG2 mit einem um N-Taktsignale verzögerten Impuls, erzeugt durch eine Steuerschaltung CON, angesteuert. Dies ist in Figur 2 zu sehen.

Die Laufzeit KBL-VZ durch die kombinatorische Schaltung KBL kann aber extrem wertabhängig sein. Das bedeutet, daß in einigen Fällen bei der in Figur 2 gezeigten Schaltungsanordnung nach M < N Zyklen der Ausgangswert in das Ausgangsregister RG2 eingetaktet werden könnte. Damit ließe sich die Verarbeitungsgeschwindigkeit eines Schaltwerkes, in der die in Figur 2 gezeigte Schaltungsanordnung eingebettet ist, erhöhen.

Aus der deutschen Patentschrift DE 36 06 406 C2 ist eine Schaltungsanordnung bekannt, bei der kombinatorische Blöcke vorgesehen sind, deren Ausgangssignale an hinter diese Blöcke geschaltete Ausgangsregister abgegeben werden.

Ferner sind aus der deutschen Patentschrift DE 42 06 082 C1 und der europäischen Anmeldeschrift EP 04 56 399 A2 Schaltwerke mit kombinatorischen Blöcken und Speichereinheiten bekannt.

Das U.S.-Patent 3,947,671 beschreibt einen Addierer bestehend aus einer Zeile parallel geschalteter Volladdierer. Einige der Eingangsanschlüsse der Volladdierer stehen mit Nachweisschaltungen in Verbindung, welche die Eingangswerte erfassen und dabei ermitteln, ob an dem jeweiligen Volladdierer ein Übertrag zu dem Volladdierer der nächsthöheren Wertigkeit auftreten kann. In Abhängigkeit von den Ergebnissen dieser Überwachung wird die Anzahl der Takte, die für die Fertigstellung der Additionsberechnung benötigt werden, eingestellt.

In dem Patent Abstracts of Japan, Band 009, Nr. 129, 5. Juni 1985, zu der Publikationsnr. JP 60014325 A ist ein Addierer beschrieben, welcher aus zwei parallel zueinander angeordneten 4-Bit Addierern aufgebaut ist. Die beiden zu addierenden höchstwertigen Bits des niederwertigeren 4-Bit Addierers werden daraufhin untersucht, ob ein Übertrag zwischen den beiden 4-Bit Addierern auftreten kann. Sofern kein Übertrag auftreten kann, wird ein Taktgeber eingesetzt, welcher einen Takt erzeugt, dessen Dauer der Rechenzeit eines 4-Bit Addierers entspricht.

In der U.S.-Patentschrift 4,276,607 ist ein Multiplizierer beschrieben, der seine Operatoren aus einem Eingangsregister bezieht. Gleichzeitig werden die Operatoren von einer Nachweisschaltung auf das Vorhandensein von Bits des Wertes 1 untersucht. Ein Zähler für Verschiebe-Operationen steuert die Anzahl der während des Multiplikationsprozesses durchzuführenden Bitverschiebungen in Abhängigkeit von den festgestellten Bits des Wertes 1.

Das der Erfindung zugrunde liegende Problem besteht darin, die in Fig. 2 dargestellte Schaltungsanordnung so zu ändern, daß das Zeitverhalten besser ist. Dieses Problem wird gemäß den Merkmalen des Patentanspruches 1 gelöst.

Weiterbildungen der Erfindung ergeben sich aus den abhängigen Ansprüchen.

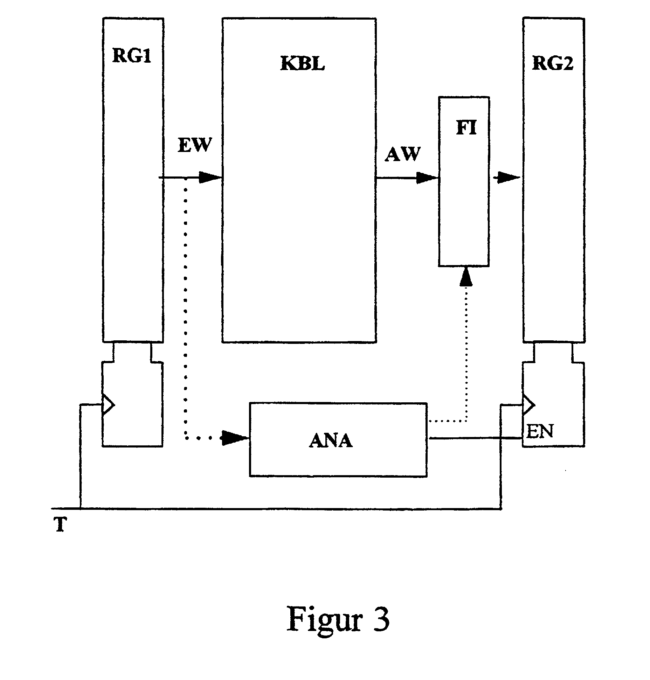

Die Erfindung wird anhand der Figuren 2 und 3 weiter erläutert.

Dabei wird mit Register RG immer ein getaktetes Speicherelement bezeichet, unabhängig davon, ob er sich nur um eine Ausführung handelt, die nur ein Bit speichert (diese wird auch mit Flip-Flop bezeichnet) oder mehrere Bits speichern kann. Ein Register bezeichnet hier nicht nur ein Speicherelement, das einen Eingangswert übernehmen sondern auch zusätzlich oder alternativ einen Wert setzen, rücksetzen (zum Beispiel JK-Flip-Flop) oder bedingt speichern (dies wird als Flip-Flop /Register mit Enable bezeichnet) kann. Des weiteren kann ein Register noch einen zusätzlichen asynchronen Setz- oder Rücksetzeingang aufweisen.

Figur 3 illustriert die Schaltungsanordnung, mit der das Zeitverhalten verbessert werden kann. Eine Analyseeinheit ANA, die die Werte EW des Ausgangs des Eingangsregisters RG1 dahingehend untersucht, ob eine Wertekombination anliegt, die das Ergebnis AW am Ausgang von KBL früher abgreifen läßt, wird eingefügt. Die Analyseeinheit ANA setzt auch das Enable-Signal EN am Ausgangsregister RG2 wertabhängig, wodurch das Ergebnis eher in das Ausgangsregister eingetaktet wird.

Es kann nun sein, daß bei bestimmten Signalen AW noch Spikes auftreten können. Um diese wegzufiltern kann die Schaltungsanordnung durch die Einheit Spike Filter FI ergänzt werden, die für diese Signale einen Wert, der sich leicht und schnell aus den Werten EW bestimmen läßt, aufprägt.

Die Schaltungsanordnung kann derart gestaltet sein, daß alle oder nur ein Teil der Eingänge durch die Einheit ANA analysiert und daß alle oder nur ein Teil der Ausgänge von KBL mit einem Spike Filter FI versehen werden.

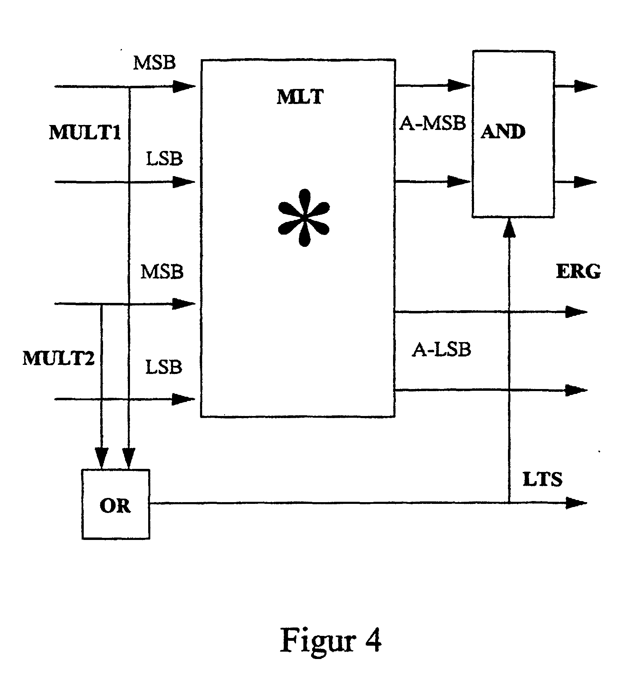

Figur 4 zeigt ein Anwendungsbeispiel der oben beschriebenen Erfindung. Dargestellt ist ein Multiplizierer MLT zur Multiplikation zweier Multiplikanten MULT1 und MULT2 mit jeweils zwei Vierbyte-Eingängen und zwei Zweibyte-Ausgängen.Die höherwertigen Eingänge(jeweils ein Byte) sind mit MSB, die niederwertigen Eingänge (jeweils ein Byte) mit LSB bezeichnet; dementsprechend sind die höherwertigen Ausgänge(jeweils zwei Byte) mit A-MSB und die niederwertigen Ausgänge (jeweils zwei Byte) mit A-LSB. Das Ergebnis der Multiplikation ist mit ERG benannt. Der Multiplizierer MLT sei rein kombinatorisch aufgebaut.

Liegen an einem oder beiden der höherwertigen Eingänge des Multiplizierers MLT nur Nullen an, das heißt es werden nur zwei kleine Zahlen multipliziert, dann kann man leicht und schnell vorhersagen (in der Schaltungsanordnung durch eine OR-Verknüpfung über alle Eingänge), daß an einem oder beiden höherwertigen Ausgängen A-MSB des Multiplizierers ebenfalls nur Nullen erscheinen werden. Diese werden über eine UND-Verknüpfung auf diese Ausgänge aufgeprägt. Des weiteren weiß man, daß die niederwertigen Stellen A-LSB des Multiplizierers früher ihre Werte erreichen werden als die des kompletten Multiplizierers. Dies wird dadurch angezeigt, daß die Leitung LTS am Ausgang der OR-Schaltung auf den Wert 0 gesetzt wird. Diese liegt an der Einheit ANA (in Figur4 nicht dargestellt) an, die das Einspeichern des Ergebnisses ERG der Multiplikation in das Ausgangsregister RG2 kontrolliert. Damit kann das Enable-Signal EN für dieses Register eher ausgelöst werden und das Ergebnis ERG schneller in das Ausgangregister RG2 eingespeichert und somit schneller weiterverarbeitet werden.

## Patentansprüche

1. Schaltungsanordnung mit zwischen Registern (RG) angeordneten kombinatorischen Blöcken (KBL),
bei der der Ausgang des vor die kombinatorischen Blöcke (KBL) geschalteten Eingangsregisters (RG1) mit einer Analyseeinheit (ANA) verbunden ist, die den Wert (EW) des Ausgangs des Eingangsregisters (RG1) untersucht und ein Übernahmesignal(EN) für das hinter die kombinatorischen Blöcke geschaltete Ausgangsregister (RG2) abgibt, wenn der Ausgangswert (AW) der kombinatorischen Blöcke (KBL) entsprechend dem Wert (EW) des Ausgangs des Eingangsregisters (RG1) vorliegen muß.

2. Schaltungsanordnung nach Anspruch 1,
bei der zwischen kombinatorischen Blöcken (KBL)und Ausgangsregister (RG2) ein Spike Filter (FI) geschaltet ist.

3. Schaltungsanordnung nach Anspruch 1 oder 2,
bei der der kombinatorische Block (KBL) ein Multiplizierer (MLT) ist,
bei der die Analyseeinheit (ANA) dann ein Übernahmesignal (EN) abgibt, wenn die höherwertigen Stellen (MSB) der Multiplikanten (MULT1, MULT2) null sind,
bei der hinter dem Multiplizierer eine logische Schaltung angeordnet ist, der die höherwertigen Stellen (A-MSB) des Ausgangswertes des Multiplizierers für diesen Fall auf null setzt.

## Claims

1. Circuit arrangement having combinatorial blocks (KBL) arranged between registers (RG),
in which the output of the input register (RG1) connected upstream of the combinatorial blocks (KBL) is connected to an analysis unit (ANA) which examines the value (EW) at the output of the input register (RG1) and outputs a transfer signal (EN) for the output register (RG2) connected downstream of the combinatorial blocks if the output value (AW) from the combinatorial blocks (KBL) needs to be available in line with the value (EW) at the output of the input register (RG1).

2. Circuit arrangement according to Claim 1,
in which a spike filter (FI) is connected between combinatorial blocks (KBL) and output register (RG2).

3. Circuit arrangement according to Claim 1 or 2,
in which the combinatorial block (KBL) is a multiplier (MLT),
in which the analysis unit (ANA) outputs a transfer signal (EN) when the more significant bits (MSB) of the multiplicands (MULT1, MULT2) are zero,
in which the multiplier has a logic circuit arranged downstream of it which sets the more significant bits (A-MSB) of the output value from the multiplier to zero for this case.

## Revendications

1. Circuit comportant des blocs combinatoires (KBL) disposés entre des registres (RG),
dans lequel la sortie du registre d'entrée (RG1) branché devant les blocs combinatoires (KBL) est reliée à une unité d'analyse (ANA) qui examine la valeur (EW) de la sortie du registre d'entrée (RG1) et qui fournit un signal de prise en charge (EN) pour le registre de sortie (RG2) branché derrière les blocs combinatoires lorsque la valeur de sortie (AW) des blocs combinatoires (KBL) doit être présente en fonction de la valeur (EW) de la sortie du registre d'entrée (RG1).

2. Circuit selon la revendication 1,
dans lequel un filtre de pointes dit Spike Filter (FI) est branché entre les blocs combinatoires (KBL) et le registre de sortie (RG2).

3. Circuit selon la revendication 1 ou 2,
dans lequel le bloc combinatoire (KBL) est un multiplicateur (MLT),
dans lequel l'unité d'analyse (ANA) fournit un signal de prise en charge (EN) lorsque les positions de poids fort (MSB) des multiplicandes (MULT1, MULT2) sont nulles,
dans lequel il y a derrière le multiplicateur un circuit logique qui met dans ce cas à zéro les positions de poids fort (A-MSB) de la valeur de sortie du multiplicateur.
